# EUROPÄISCHE PATENTSCHRIFT

(11) **EP 3 035 377 B1**
(45) Veröffentlichungstag und Bekanntmachung des Hinweises auf die Patenterteilung: **28.02.2018**
(21) Anmeldenummer: 15165409.2
(22) Anmeldetag: 28.04.2015
(51) Int. Cl.: H01L 21/683, H01L 21/67

(54) **VAKUUMSPANNVORRICHTUNG ZUM AUFSPANNEN VON WERKSTÜCKEN**
VACUUM TENSIONING DEVICE FOR CLAMPING WORKPIECES
DISPOSITIF DE SERRAGE À VIDE DE PIÈCES À USINER

(30) Priorität: 17.12.2014 DE 102014118830
(43) Veröffentlichungstag der Anmeldung: 22.06.2016
(73) Patentinhaber: mechatronic systemtechnik gmbh, 9500 Villach (AT)
(72) Erfinder: Oremus, Alexander, 9500 Villach (AT)
(74) Vertreter: Müller & Schubert

(56) Entgegenhaltungen:
- JP-A- S60 146 675
- KR-A- 20000 065 924
- US-A1- 2006 055 073
- US-A1- 2008 111 984
- US-B1- 6 722 642

## Beschreibung

Die vorliegende Erfindung betrifft eine Vakuumspannvorrichtung zum Aufspannen von Werkstücken, insbesondere zum Aufspannen von flachen Substraten.

Derartige Vakuumspannvorrichtungen sind im Stand der Technik grundsätzlich bereits bekannt. Generell verfügen solche Vakuumspannvorrichtungen über eine Vakuumspannplatte, die über ihre Fläche verteilt eine Anzahl von Ansaugöffnungen aufweist, die in einer Ansaugoberfläche der Vakuumspannplatte ausgebildet sind, oder die mit einer Anzahl von Ansaugnuten in Verbindung stehen, die in einer Ansaugoberfläche der Vakuumspannplatte ausgebildet sind. Vakuumspannvorrichtungen der genannten Art werden in den unterschiedlichsten technischen Gebieten eingesetzt.

Ein solches technisches Gebiet stellt die Herstellung und Bearbeitung von Substraten in Form von Wafern dar. Ein Wafer ist grundsätzlich eine kreisrunde oder viereckige Scheibe, auf der sich elektronische Bauelemente befinden. Während der Bearbeitung solcher Wafer befinden sich diese in der Regel auf beziehungsweise in einer Bearbeitungsvorrichtung, die beispielsweise einen Bearbeitungstisch aufweisen kann. Der Bearbeitungstisch verfügt über eine Halteeinrichtung, auf der der Wafer während der Bearbeitung angeordnet ist, und auf der der Wafer, beispielsweise mittels Vakuum, angesaugt wird oder ist. Während des Bearbeitungsvorgangs ist der Wafer üblicherweise Kräften ausgesetzt, so dass das Bedürfnis besteht, den Wafer gegen ein Verrutschen zu sichern.

Dazu ist es im Stand der Technik beispielsweise bereits bekannt geworden, die Vakuumspannplatte in zwei oder mehr voneinander getrennte, einzeln schaltbare Vakuumzonen aufzuteilen, wobei jede Vakuumzone entsprechende Ansaugöffnungen und/oder Ansaugnuten mit Ansaugöffnungen aufweist. Eine solche Lösung ist in der DE 10 2004 016 476 B4 beschrieben. Durch die bekannte Lösung wird es ermöglicht, die Größe der Vakuumspannplatte an die Größe des aufzuspannenden Werkstücks anzupassen. Je nach Größe des Werkstücks werden dann entsprechend viele beziehungsweise entsprechend gestaltete Vakuumzonen zu einer einzigen Vakuumspannplatte zusammengeschaltet. Im Betrieb der bekannten Lösung steht dann jedoch immer nur ein einziger Vakuumkreis zur Verfügung, der ein über die gesamte Vakuumspannvorrichtung einheitliches Vakuum erzeugt oder bereitstellt.

In anderem Zusammenhang ist es im Stand der Technik bereits bekannt geworden, die Vakuumspannplatte an besondere Konturen des aufzuspannenden Werkstücks anzupassen. In der DE 20 2013 100 632 U1 beispielsweise wird auf der Vakuumspannplatte eine weitere Vakuumplatte aufgebraucht, beispielsweise aufgelegt, wobei die Vakuumplatte eine erste äußere Oberfläche und eine dazu gegenüberliegend zweite äußere Oberfläche aufweist und wobei die Vakuumplatte eine Anzahl von Vakuumkanälen aufweist, die sich von der ersten äußeren Oberfläche zur zweiten äußeren Oberfläche durch die Vakuumplatte hindurch erstrecken. Die Vakuumplatte, die bei der bekannten Lösung als eine Art Matte ausgebildet ist, kann sich an das aufzuspannende Werkstück anschmiegen. Die Vakuumkanäle sind mit den Ansaugöffnungen in der unter der Vakuumplatte liegenden Vakuumspannplatte verbunden, so dass das Vakuum an der Oberfläche des aufzuspannenden Werkstücks erzeugt beziehungsweise bereitgestellt werden kann.

Eine gattungsgemäße Vakuumspannvorrichtung, von der die vorliegende Erfindung ausgeht, ist in der US 2006/0055073 A1 offenbart.

In der US 2008/111984 A1 ist eine Vakuumspannvorrichtung offenbart, die zwei voneinander getrennte, einzeln schaltbare Vakuumzonen aufweist. Zudem weist die bekannte Vakuumspannvorrichtung zwei voneinander unabhängige Vakuumkreise auf, wobei jede Vakuumzone einem der Vakuumkreise zugeordnet ist.

Andere Lösungen auf dem Gebiet der Vakuumspannvorrichtungen sind beispielsweise in der JP S60 146675A, oder der KR 2000 0065924 A, oder der US 6,722,642 B1 beschrieben.

Insbesondere im Bereich der Bearbeitung von Wafern unter Verwendung einer Vakuumspannvorrichtung ist es sehr bedeutsam, dass mittels der Vakuumspannvorrichtung große Haltekräfte bereitgestellt werden, wobei insbesondere eine Beschädigung des empfindlichen Wafers zu vermeiden ist.

Ausgehend vom genannten Stand der Technik liegt der vorliegenden Erfindung die Aufgabe zugrunde, eine bekannte Vakuumspannvorrichtung derart weiterzubilden, dass mit dieser gezielt große Haltekräfte erzeugt werden können, wobei gleichzeitig eine Beschädigung der aufzuspannenden Werkstücke vermieden wird.

Diese Aufgabe wird erfindungsgemäß gelöst durch die Vakuumspannvorrichtung mit den Merkmalen gemäß dem unabhängigen Patentanspruch 1.

Weitere Merkmale und Details der Erfindung ergeben sich aus den Unteransprüchen, der Beschreibung sowie den Zeichnungen.

Die vorliegende Erfindung basiert auf dem Grundgedanken dass mit einer Vakuumspannvorrichtung zum Aufspannen von Werkstücken, insbesondere zum Aufspannen von flachen Substraten, eine, insbesondere gezielte, Vergrößerung der Haltekräfte realisiert werden kann.

Vakuumspannvorrichtungen an sich sind im Stand der Technik bereits bekannt. Dabei geht das Vakuumspannen insbesondere von dem Grundsatz aus, dass außerhalb und innerhalb einer Vakuumspannvorrichtung, die als Vakuumtisch ausgebildet sein kann oder aber ein Bestandteil eines Vakuumtischs ist, zunächst der normale atmosphärische Luftdruck anliegt, der in der Regel etwa 1 bar beträgt. Nun wird das aufzuspannende Werkstück auf die Vakuumspannvorrichtung aufgebracht. Mit einer Vakuumeinrichtung, beispielsweise eine Vakuumpumpe wird die Luft im Inneren der Vakuumspannvorrichtung abgesaugt. Dadurch entsteht eine Druckdifferenz zwischen innen und außen, deren Grenzschicht das aufzuspannende Werkstück darstellt. Zwischen dem Werkstück und der Vakuumspannvorrichtung wird somit ein Vakuum erzeugt. Hierbei handelt es sich insbesondere um einen Unterdruck, der wesentlich, das heißt der um ein Vielfaches geringer ist als der Umgebungsdruck, etwa der atmosphärische Luftdruck. Der atmosphärische Luftdruck drückt nun das Werkstück an die Vakuumspannvorrichtung an. Nun kann die Oberseite des aufgespannten Werkstücks, gegebenenfalls auch der Randbereich des Werkstücks, bearbeitet werden, ohne dass das Werkstück dabei wegrutschen kann.

Grundsätzlich ist die Erfindung nicht auf das Aufspannen bestimmter Werkstücke beschränkt. Bevorzugt wird die erfindungsgemäße Vakuumspannvorrichtung zum Aufspannen von flachen Substraten verwendet. Grundsätzlich ist die Erfindung nicht auf bestimmte Arten von Substraten beschränkt. Bei einem Substrat kann es sich generell um eine Unterlage oder Grundlage handeln. Beispielsweise kann es sich bei dem Substrat um einen wie eingangs beschriebenen Wafer handeln, so dass die Vakuumspannvorrichtung bevorzugt zum Aufspannen von Wafern verwendet wird.

Handelt es sich bei dem Substrat um einen Wafer, so handelt es sich bei der Vakuumspannvorrichtung bevorzugt um einen so genannten Chuck oder um einen Bestandteil eines solchen Chucks. Ein Chuck stellt insbesondere eine Halterung dar, die beispielsweise an dem Bearbeitungstisch montiert ist, oder aber die einen solchen Bearbeitungstisch darstellt. Der Chuck nimmt den Wafer beispielsweise mittels eines erzeugten Vakuums auf.

Die Vakuumspannvorrichtung weist eine Vakuumspannplatte auf, die über ihre Fläche verteilt eine Anzahl von Ansaugöffnungen aufweist. Dabei ist die Erfijdung nicht auf eine bestimmte Anzahl von Ansaugöffnungen beschränkt. Die geeignete Anzahl ergibt sich insbesondere aus der Größe und Form des aufzuspannenden Werkstücks und die Größe der zu erzeugenden Haltekräfte. In jedem Fall sind bevorzugt mehr als zwei solcher Ansaugöffnungen vorgesehen. Über die Ansaugöffnungen wird das Vakuum im Bereich des aufzuspannenden Werkstücks erzeugt beziehungsweise bereitgestellt, indem bei Erzeugung des Vakuums über die Ansaugöffnungen das Werkstück an der Vakuumspannplatte angesaugt wird. Grundsätzlich ist die Erfindung nicht auf bestimmte Typen von Vakuumspannplatten beschränkt. In einer bevorzugten Ausführungsform kann vorgesehen sein, dass die Ansaugöffnungen in einer Ansaugoberfläche der Vakuumspannplatte ausgebildet sind. Bei dieser Ausführungsform münden die Ansaugöffnungen in der Ansaugoberfläche und durchbrechen diese. In der Ansaugoberfläche befinden sich somit eine Anzahl von Ansaugöffnungen, bei denen es sich beispielsweise um Bohrungen handeln kann, und die mit einer Einrichtung zum Erzeugen des Vakuums verbunden sind, wie weiter unten noch näher erläutert wird. In einer anderen bevorzugten Ausführungsform ist vorgesehen, dass die Ansaugöffnungen mit einer Anzahl von Ansaugnuten in Verbindung stehen, die in einer Ansaugoberfläche der Vakuumspannplatte ausgebildet sind. In diesem Fall wird das Vakuum an sich über die Ansaugnuten erzeugt beziehungsweise bereitgestellt, wobei die Ansaugnuten ebenfalls mit Ansaugöffnungen verbunden sind. In diesem Ausführungsbeispiel können jedoch insgesamt weniger Ansaugöffnungen vorgesehen sein.

Nachfolgend wird nun ein erstes bevorzugtes Ausführungsbeispiel beschrieben, wie eine erfindungsgemäße Vakuumspannvorrichtung ausgestaltet sein kann.

Erfindungsgemäß wird eine Vakuumspannvorrichtung zum Aufspannen von Werkstücken, insbesondere zum Aufspannen von flachen Substraten, bereitgestellt, mit einer Vakuumspannplatte, die über ihre Fläche verteilt eine Anzahl von Ansaugöffnungen aufweist, die in einer Ansaugoberfläche der Vakuumspannplatte ausgebildet sind, oder die mit einer Anzahl von Ansaugnuten in Verbindung stehen, die in einer Ansaugoberfläche der Vakuumspannplatte ausgebildet sind, wobei die Vakuumspannplatte zwei oder mehr voneinander getrennte, einzeln schaltbare Vakuumzonen aufweist, wobei jede Vakuumzone entsprechende Ansaugöffnungen und/oder Ansaugnuten mit Ansaugöffnungen aufweist. Die Vakuumspannvorrichtung weist zwei oder mehr voneinander unabhängige Vakuumkreise auf, wobei jede Vakuumzone einem der Vakuumkreise zugeordnet ist oder Bestandteil eines der Vakuumkreise ist, und wobei jeder Vakuumkreis zum Erzeugen eines eigenständigen Vakuums ausgebildet ist.

In Ergänzung zu den weiter oben bereits beschriebenen Merkmalen ist bei der Vakuumspannvorrichtung vorgesehen, dass die Vakuumspannplatte zwei oder mehr voneinander getrennte, einzeln schaltbare Vakuumzonen aufweist, wobei jede Vakuumzone entsprechende Ansaugöffnungen und/oder Ansaugnuten mit Ansaugöffnungen aufweist. Eine solche Ausgestaltung der Vakuumspannplatte in zwei oder mehr Vakuumzonen ist, wie weiter oben schon erwähnt, grundsätzlich aus der DE 10 2004 016 476 B4 bekannt.

Im Unterschied zu der aus dieser Druckschrift bekannten Lösung ist erfindungsgemäß jedoch vorgesehen, dass die Vakuumspannvorrichtung zwei oder mehr voneinander unabhängige Vakuumkreise aufweist. Ein Vakuumkreis besteht grundsätzlich aus einer Reihe unterschiedlicher Elemente, die erforderlich sind, damit ein Vakuum erzeugt oder bereitgestellt werden kann. Die in der Ansaugoberfläche der Vakuumspannplatte befindlichen Ansaugöffnungen sind insbesondere mit Vakuumkanälen oder Vakuumleitungen verbunden. Diese Vakuumkanäle beziehungsweise Vakuumleitungen sind insbesondere über Anschlusselemente, beispielsweise entsprechende Ventilelemente, mit einer Einrichtung zum Erzeugen von Vakuum, beispielsweise einer Vakuumpumpe, verbunden. Grundsätzlich kann festgehalten werden, dass ein Vakuumkreis aus einer Einrichtung zum Erzeugen eines Vakuums, beispielsweise einer Vakuumpumpe, einem Unterdruckbereich und der mit den Ansaugöffnungen versehenen Vakuumspannplatte besteht. Die einzelnen Bauteile können über Kanäle und Leitungen, beispielsweise über Schläuche, etwa Pneumatikschläuche, gegebenenfalls unter weiterer Verwendung von Ventilen, mit einander verbunden sein. Wird über die Einrichtung zum Erzeugen des Vakuums in dem Unterdruckbereich der Luftdruck verringert, entsteht eine Haltekraft.

Erfindungsgemäß ist im Unterschied zu der DE 10 2004 016 476 B4 nunmehr vorgesehen, dass jede Vakuumzone einem der Vakuumkreise zugeordnet ist oder Bestandteil eines der Vakuumkreise ist, und dass jeder Vakuumkreis zum Erzeugen eines eigenständigen Vakuums ausgebildet ist. Bei der bekannten Lösung hingegen ist insgesamt nur ein einziger Vakuumkreis vorgesehen, dem sämtliche Vakuumzonen zugeordnet sind. Dies liegt daran, dass bei der bekannten Lösung erreicht werden soll, dass die Vakuumspannplatte von ihrer Größe her möglichst genau an das aufzuspannende Werkstück angepasst werden soll, so dass bei Bedarf einzelne Vakuumzonen zu einer einzigen Vakuumspannplatte zusammengeschaltet werden.

Mit der Lösung gemäß der vorliegenden Erfindung wird nun ein gänzlich anderer Weg beschritten. Hier ist jede Vakuumzone einem eigenen Vakuumkreis zugeordnet. Bei der erfindungsgemäßen Lösung gibt es wenigstens zwei solcher Vakuumkreise, die unabhängig voneinander sind, und mittels derer jeweils unabhängig ein Vakuum erzeugt werden kann. Eine Vakuumzone, die einem bestimmten Vakuumkreis zugeordnet ist, kann deshalb ein Vakuum erzeugen oder bereitstellen, welches unabhängig ist von einem Vakuum, welches über eine Vakuumzone erzeugt oder bereitgestellt wird, welche einem anderen Vakuumkreis zugeordnet ist.

Mit der vorliegenden Erfindung werden somit nicht nur wenigstens zwei Vakuumzonen bereitgestellt, die konstruktiv voneinander getrennt sind, sondern die zudem auch noch funktional, was die Erzeugung und die Bereitstellung eines Vakuums betrifft, voneinander getrennt sind. Je nach Ausgestaltung und Anordnung der einzelnen Vakuumzonen in der Vakuumspannplatte kann deshalb an definierten Stellen sehr genau und schnell das jeweils gewünschte Vakuum erzeugt oder bereitgestellt werden. Einige bevorzugte Ausführungsbeispiele hierzu werden im weiteren Verlauf der Beschreibung noch näher erläutert.

Beispielsweise kann vorgesehen sein, dass die Vakuumspannplatte in eine größere Anzahl von zwei oder mehr Vakuumzonen aufgeteilt ist. Bei dieser Ausgestaltung kann durchaus vorgesehen sein, dass jeweils mehrere Vakuumzonen einem Vakuumkreis zugeordnet sind. Dennoch sind mindestens zwei Vakuumkreise vorgesehen, so dass jedem Vakuumkreis mindestens eine Vakuumzone zugeordnet ist. In einer anderen bevorzugten Ausführungsform kann vorgesehen sein, dass jede Vakuumzone einem eigenen Vakuumkreis zugeordnet ist, so dass mittels jeder der Vakuumzonen ein in Bezug auf die anderen Vakuumzonen und unabhängig von den anderen Vakuumzonen jeweils ein eigenständiges Vakuum erzeugt oder bereitgestellt werden kann.

Bevorzugt sind die einzelnen Vakuumzonen getrennt voneinander ausgebildet und durch entsprechende Barrieren beziehungsweise Isolatoren voneinander getrennt. Die einzelnen Vakuumzonen werden dann anschließend zu der Vakuumspannplatte zusammengefügt. Da jede der Vakuumzonen einem eigenen Vakuumkreiszugeordnet ist, können diese völlig unabhängig voneinander betrieben werden. Es ist somit möglich, dass, wie weiter unten noch näher beschrieben wird, über die gesamte Vakuumspannplatte gesehen Bereiche mit jeweils unterschiedlichem Vakuum bereitgestellt werden, so dass mit der erfindungsgemäßen Vakuumspannvorrichtung Bereiche mit unterschiedlich großen Haltekräften realisiert werden können.

Grundsätzlich ist die Erfindung nicht auf eine bestimmte Anzahl von Vakuumzonen beschränkt. In einer bevorzugten Ausführungsform ist die Vakuumspannplatte in zwei Vakuumzonen aufgeteilt, wobei eine erste Vakuumzone flächenmäßig um ein Vielfaches größer ist als die zweite Vakuumzone.

In einer anderen bevorzugten Ausführungsform ist die Vakuumspannplatte alternativ oder in weiterer Ausgestaltung in zwei Vakuumzonen aufgeteilt, wobei über eine erste Vakuumzone ein Vakuum erzeugt oder bereitgestellt wird, das größer, insbesondere um ein Vielfaches größer, ist als das Vakuum, dass über die zweite Vakuumzone erzeugt oder bereitgestellt wird.

Die Form der Vakuumzonen, insbesondere deren Größe und/oder Kontur, ebenso wie das über die Vakuumzonen erzeugte oder bereitgestellte Vakuum kann je nach Ausgestaltung frei ausgestaltbar sein.

Die Vakuumspannplatte ist kreisförmig ausgebildet, wobei wenigstens eine Vakuumzone als Kreissektor oder als Kreissegment ausgebildet ist. Wenn die Vakuumzonen unterschiedlich groß ausgebildet sind, handelt es sich insbesondere bei der kleineren Vakuumzone um einen solchen Kreissektor oder ein solches Kreissegment. Ein Kreissektor oder auch Kreisausschnitt ist insbesondere der Teil der Fläche eines Kreises, der von den Schenkeln eines Zentriwinkels und dem zugehörigen Kreisbogen begrenzt wird. Ein Kreissegment oder auch Kreisabschnitt ist der Teil der Fläche eines Kreises, der von einer Sehne und einem der Sehne zugehörigen Kreisbogen begrenzt wird. Ist ein Kreissegment vorgesehen, wird der Kreis von der Sehne in zwei Segmente getrennt.

Durch die erfindungsgemäße Vakuumspannvorrichtung wird mindestens eine zusätzliche, über einen eigenen separaten Vakuumkreis betriebene Vakuumzone bereitgestellt, die die Klemmung des Werkstücks deutlich verbessern kann. So kann etwa vorgesehen sein, dass es für eine optimale Aufspannung des Werkstücks an der Vakuumspannvorrichtung wünschenswert ist, wenn in unterschiedlichen Bereichen ein unterschiedliches Vakuum erzeugt oder bereitgestellt wird. Dies kann mit der vorliegenden Erfindung realisiert werden, was nachfolgend anhand eines nicht ausschließlichen Beispiels aus dem Bereich der Waferbearbeitung verdeutlicht wird.

Während der Bearbeitung von Wafern ist nicht selten vorgesehen, dass diese, zumindest auf einer ihrer Oberflächen und zumindest zeitweilig, mit einer Folie abgedeckt werden, wobei diese Folie in der Regel auf den Wafer auflaminiert wird. Diese Folie erfüllt in manchen Anwendungen eine Schutzfunktion und ist insofern als Schutzfolie ausgebildet. Im weiteren Stadium der Bearbeitung der Wafer müssen diese Schutzfolien dann wieder entfernt werden. Dies geschieht in der Regel mittels einer dafür vorgesehenen Folien-Abziehvorrichtung. Die Folien-Abziehprozedur, die auch als Folien-Peeling-Prozedur bezeichnet werden kann, wird in der Regel in einer Weise durchgeführt, dass eine besondere Abziehfolie oder Peeling-Folie an die abzuziehende Schutzfolie angeschweißt wird. Anschließend wird die Abziehfolie mittels der Abziehvorrichtung gezogen, wobei die an der Abziehfolie angeschweißte Schutzfolie mit abgezogen wird. In demjenigen Bereich, in dem die Abziehfolie angeschweißt wird, und in der der anschließende Abziehvorgang beginnt, wozu eine initiale Abziehkraft aufgebracht werden muss, kann es vorteilhaft sein, wenn die Haltekraft, mit der der Wafer von der Vakuumspannvorrichtung gehalten wird, größer ist als im übrigen Bereich. Durch die vorliegende Erfindung ist es nun möglich in diesem Abziehbereich der Folie eine eigene Vakuumzone mit eigenem dazugehörigen Vakuumkreis vorzusehen, so dass in diesem Bereich ein anderes Vakuum erzeugt oder bereitgestellt werden kann, als dies im übrigen Bereich der Fall ist.

Erfindungsgemäß ist die Vakuumspannplatte als exzentrische Vakuumspannplatte ausgebildet.

Überraschender Weise wurde herausgefunden, dass auch durch eine solche exzentrische Form der Vakuumspannplatte die Haltekräfte weiter vergrößert werden können.

Eine exzentrische Vakuumspannplatte zeichnet sich dadurch aus, dass diese Bereiche aufweist, die keinen gemeinschaftlichen Mittelunkt haben.

Erfindungsgemäß ist die Vakuumspannplatte kreisförmig ausgebildet, und die Vakuumspannplatte weist wenigstens zwei Bereiche auf, die keinen gemeinschaftlichen Mittelpunkt haben. Das bedeutet, dass der Umfang der Vakuumspannplatte zumindest bereichsweise unterschiedliche Kreisbahnen beschreibt.

Die Vakuumspannplatte ist kreisförmig ausgebildet, die Vakuumspannplatte weist zwei oder mehr voneinander getrennte, einzeln schaltbare Vakuumzonen auf, wobei jede Vakuumzone entsprechende Ansaugöffnungen und/oder Ansaugnuten mit Ansaugöffnungen aufweist, und die Vakuumzonen weisen kreisförmige äußere Begrenzungen auf, die keinen gemeinsamen Mittelunkt haben.

Wenn die Vakuumspannplatte beispielsweise zwei Vakuumzonen aufweist, wobei eine erste größere Vakuumzone vorgesehen ist, und wobei eine zweite, kleinere Vakuumzone vorgesehen ist, welche beispielsweise als Kreissegment ausgebildet ist, kann die größere Vakuumzone beispielsweise kreisförmig ausgebildet sein, während die zweite Vakuumzone in Form eines Kreissegments einen Kreisbogen aufweist, der hierzu exzentrisch ist, was bedeutet, dass die Begrenzungen der beiden Vakuumzonen keinen gemeinsamen Mittelunkt haben.

In weiterer Ausgestaltung kann die Vakuumspannplatte als Vakuumplatte ausgebildet oder vor der Vakuumspannplatte eine Vakuumplatte angeordnet sein, wobei die Vakuumplatte eine erste äußere Oberfläche und eine dazu gegenüberliegend zweite äußere Oberfläche aufweist und wobei die Vakuumplatte eine Anzahl von Vakuumkanälen aufweist, die sich von der ersten äußeren Oberfläche zur zweiten äußeren Oberfläche durch die Vakuumplatte hindurch erstrecken, wobei zumindest einzelne Vakuumkanäle sich von einer senkrechten Ausrichtung abweichend zwischen den äußeren Oberflächen durch die Vakuumplatte hindurch erstrecken und/oder wobei zumindest einzelne Vakuumkanäle eine von einer zylindrischen Form abweichende Form aufweisen.

Um ein Werkstück gegen Verrutschen zu sichern ist es insbesondere sinnvoll, zwischen dem Werkstück und der Vakuumspannplatte eine solche weitere Vakuumplatte vorzusehen, die bevorzugt zwischen Vakuumspannplatte und Werkstück angeordnet ist. Eine solche Vakuumplatte soll sowohl luftdurchlässig sein, was durch die Vakuumkanäle erreicht wird, als auch einen hohen Reibwiderstand haben, was insbesondere durch das für die Vakuumplatte verwendete Material erreicht wird.

In einer bevorzugten Ausführungsform ist vorgesehen, dass die weitere Vakuumplatte an der Vakuumspannplatte fixiert, beispielsweise angeklebt, ist.

Die Vakuumplatte ist von einer Anzahl von Vakuumkanälen durchsetzt. Ein Vakuumkanal ist dabei insbesondere ein röhrenförmiger Verbindungsgang zwischen zwei Oberflächen der Vakuumplatte, wobei die Enden des Verbindungsgangs an den Oberflächen liegen, der Verbindungsgang somit in den Oberflächen mündet. Die Vakuumplatte weist dazu zwei äußere Oberflächen auf, wobei sich die Vakuumkanäle zwischen den äußeren Oberflächen durch die Vakuumplatte hindurch erstrecken, so dass die Enden der Vakuumkanäle in den äußeren Oberflächen münden und die Vakuumplatte somit durchbrechen. Eine Vakuumplatte mit solchen Vakuumkanälen ist im Stand der Technik grundsätzlich bekannt und beispielsweise ein der weiter oben erwähnten DE 20 2013 100 632 U1 erwähnt. Bei dieser bekannten Lösung ist jedoch vorgesehen, dass sich die Vakuumkanäle senkrecht durch die Vakuumplatte hindurch erstrecken.

Im Unterschied zu der bekannten Lösung wurde nun überraschender Weise herausgefunden, dass die Haltekräfte gezielt vergrößert werden können, wenn die Vakuumkanäle im Vergleich zu der bekannten Lösung anders ausgebildet sind, nämlich derart, dass zumindest einzelne Vakuumkanäle sich von einer senkrechten Ausrichtung abweichend zwischen den äußeren Oberflächen durch die Vakuumplatte hindurch erstrecken und/oder dass zumindest einzelne Vakuumkanäle eine von einer zylindrischen Form abweichende Form aufweisen. Ein Zylinder ist grundsätzlich ein von zwei parallelen ebenen Flächen, einer Grund- und einer Deckelfläche, und von einem Mantel beziehungsweise einer Zylinderfläche begrenzter Körper, wobei die Mantelfläche von parallelen Geraden gebildet wird. Ein Zylinder ist insbesondere ein röhrenförmiger Hohlkörper.

Grundsätzlich ist die Erfindung nicht auf bestimmte Ausführungsformen hinsichtlich der Ausrichtung und/oder Form der Vakuumkanäle beschränkt. Bevorzugt können sich zumindest einzelne Vakuumkanäle mit einem schrägen Verlauf zwischen den äußeren Oberflächen durch die Vakuumplatte hindurch erstrecken und/oder zumindest einzelne Vakuumkanäle können einen konischen Verlauf haben. In weiterer Ausgestaltung ist auch denkbar, dass mehrere Verbindungskanäle in einem einzigen Punkt zusammenlaufen. Die Verbindungskanäle dienen dazu, dass darüber Luft abgesaugt wird, damit der Unterdruck beziehungsweise das Vakuum entstehen kann. Durch die besondere Ausgestaltung der Vakuumkanäle und/oder deren besondere Ausrichtung ist es möglich, die Haltekräfte so einzustellen, wie sie für ein sicheres Halten des Werkstücks benötigt werden.

In einer bevorzugten Ausführungsform sind in der Vakuumplatte zumindest einzelne Vakuumkanäle mit jeweils unterschiedlicher Ausrichtung und/oder mit jeweils unterschiedlicher Form ausgebildet sind. Das bedeutet, dass in der Vakuumplatte jeweils Vakuumkanäle mit unterschiedlichen Ausrichtungen und/oder Formen ausgebildet sein können. Beispielsweise können als Vakuumkanäle senkrechte oder schräge Bohrungen mit geringem Durchmesser realisiert werden. Ein Vakuumkanal in einer erfindungsgemäßen Vakuumplatte kann beispielsweise einen Durchmesser von 50µm aufweisen. Zur Strömungsoptimierung können als Vakuumkanäle Bohrungen mit verschiedenen Geometrien, beispielsweise zylindrisch, konisch und dergleichen, vorgesehen sein.

Die Vakuumplatte kann aus einem beliebigen Werkstoff bestehen. Bestanden derartige Vakuumplatten bislang bevorzugt aus einem porösen Material, beispielsweise aus Keramik, so sind wegen der Verwendung der Vakuumkanäle nunmehr auch andere Materialien für die Vakuumplatte möglich, so dass diese beispielsweise auch aus Metall, Kunststoff oder dergleichen gebildet sein kann.

Die Verbindungskanäle können auf beliebige Weise in die Vakuumplatte eingebracht werden, beispielsweis mittels Laserbohren, Laserablation, Ätzen oder dergleichen.

In weiterer Ausgestaltung ist bevorzugt vorgesehen, dass die Vakuumspannplatte eine Größe und/oder Kontur aufweist, die mit der Größe und/oder Kontur des zu spannenden Werkstücks, insbesondere des zu spannenden flachen Substrats, korrespondiert.

Bevorzugt kann weiterhin vorgesehen sein, dass die Vakuumspannplatte in deren Peripheriebereich zumindest bereichsweise einen Überstand aufweist. Als Überstand wird dabei insbesondere ein Bereich verstanden, der sich über die Vakuumspannplatte hinaus nach außen erstreckt. Wenn sich auf der Vakuumspannplatte ein Werkstück befindet, steht der Überstand somit über die Ränder des aufgespannten Werkstücks, beispielsweiseeines Wafers, über.

In dem Überstand ist bevorzugt eine Einrichtung zum Absaugen von Luft vorgesehen. Beispielsweise kann dazu in dem Überstand wenigstens eine Absaugöffnung vorgesehen sein, über die Luft abgesaugt werden kann. Natürlich können auch mehrere solcher Absaugöffnungen vorhanden sein. Damit kann Luft am Rand des aufgespannten Werkstücks, beispielsweise eines Wafers abgesaugt werden. Wenn beispielsweise eine partielle Ablösung des Werkstücks von der Vakuumspannplatte erfolgt, wodurch ein Spalt entsteht, in den Luft mit Umgebungsdruck eindringen kann, wodurch das über die Vakuumspannplatte erzeugte oder bereitgestellte Vakuum zusammenbrechen könnte, wird dies durch den Überstand mit der Absaugöffnung verhindert, da solche Luft gleich abgesaugt wird und somit gar nicht erst in den durch die partielle Ablösung entstehenden Spalt gelangen kann.

Die vorliegende Erfindung ist nicht auf bestimmte Ausführungsformen für die Ausgestaltung des Überstands beschränkt. Beispielsweise kann der Überstand umlaufend im Peripheriebereich der Vakuumspannplatte angeordnet oder ausgebildet sein. In anderer Ausgestaltung kann der Überstand in Form wenigstens eines Überstandabschnitts im Peripheriebereich der Vakuumspannplatte angeordnet oder ausgebildet ist. Bei einem solchen Überstandabschnitt kann es sich beispielsweise um eine Art Nase oder Lasche handeln. Die Überstandabschnitte sind bevorzugt beabstandet voneinander entlang des Peripheriebereichs der Vakuumspannplatte angeordnet oder ausgebildet. Sind wie vorstehend beschriebene Absaugöffnungen vorgesehen, ist bevorzugt in jedem Überstandabschnitt wenigstens eine solche Absaugöffnung ausgebildet.

Die Erfindung wird nun anhand von Ausführungsbeispielen unter Bezugnahme auf die beiliegenden Zeichnungen näher erläutert. Es zeigen
- Figur 1: in schematischer Ansicht ein Ausführungsbeispiel einer erfindungsgemäßen Vakuumspannplatte; und
- Figur 2: in schematischer Ansicht eine Vakuumplatte, die vor der Vakuumspannplatte angeordnet ist.

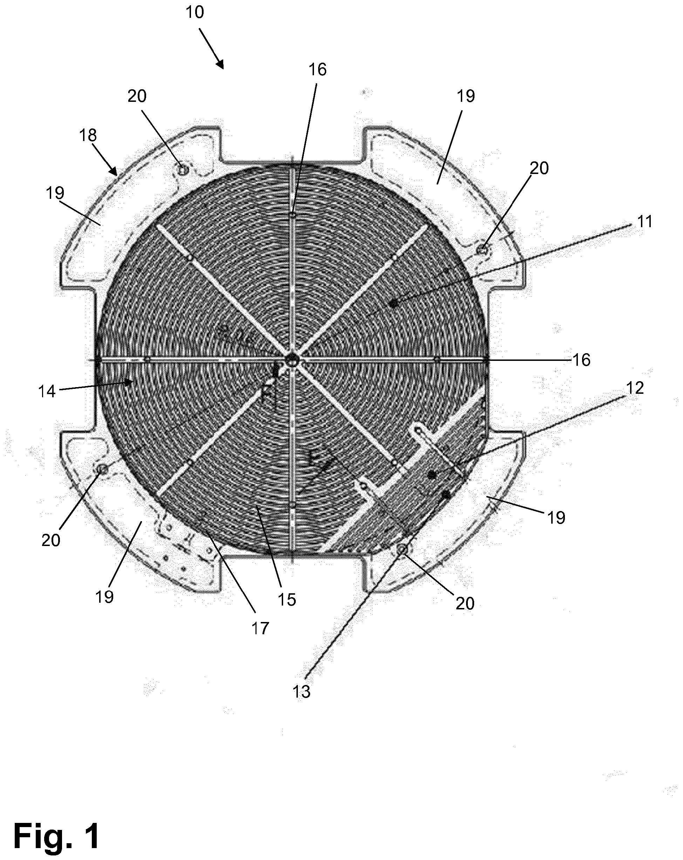

In Figur 1 ist eine Vakuumspannplatte 10 für eine Vakuumspannvorrichtung dargestellt, wobei mit der Vakuumspannvorrichtung Wafer aufgespannt werden sollen. Die Vakuumspannplatte 10, die kreisförmig ausgebildet ist, weist zwei voneinander getrennte, einzeln schaltbare Vakuumzonen 11, 12 auf, wobei eine kleinere Vakuumzone 12, die als Kreissegment ausgebildet ist, im Vergleich zu einer ersten größeren Vakuumzone 11 eine exzentrische Form 13 aufweist. Jede der Vakuumzonen 11, 12 ist einem eigenen Vakuumkreis zugeordnet, so dass in jeder der beiden Vakuumzonen 11, 12 ein eigenständiges, unabhängiges Vakuum erzeugt werden kann. Die Erzeugung des Vakuums erfolgt derart, dass die Vakuumspannplatte 10 insgesamt eine Ansaugoberfläche 14 aufweist, auf der sich Ansaugnuten 15 befinden. Weiterhin ist eine Reihe von Ansaugöffnungen 16 vorgesehen, die mit den Ansaugnuten 15 in Verbindung stehen.

Wird nun ein Wafer (nicht dargestellt) auf der Vakuumspannplatte aufgespannt, wird dieser zunächst auf die Vakuumspannplatte aufgelegt. Anschließend wird Luft über die Ansaugnuten 15 und die Ansaugöffnungen 16 angesaugt, was über eine nicht dargestellte Einrichtung zum Erzeugen eines Vakuums, beispielsweise eine Vakuumpumpe, erfolgt. Dazu ist die Vakuumpumpe über eine geeignete Unterdruckeinrichtung, die beispielsweise Kanäle, Leitungen, Ventile und dergleichen umfassen kann, mit den Ansaugöffnungen 16 verbunden.

Dadurch, das die Vakuumspannplatte 10 zwei unterschiedliche, voneinander getrennte Vakuumkreise mit jeweils einer Vakuumzone 11 und einer Vakuumzone 12 aufweist, und dadurch, dass die eine Vakuumzone 12 eine exzentrische Form 13 aufweist, können die Haltekräfte für den Wafer vergrößert werden, wobei die Vergrößerung der Haltekräfte bevorzugt gezielt erfolgen kann. Wenn mit der kleineren Vakuumzone beispielsweise ein im Vergleich zur größeren Vakuumzone 11 größeres Vakuum erzeugt oder bereitgestellt werden soll, kann im Bereich der Vakuumzone 12 sehr genau und gezielt eine größere Haltekraft erzeugt werden, was in machen Wafer-Bearbeitungsvorgängen von Vorteil ist.

Über den Peripheriebereich 17 der Vakuumspannplate10 erstreckt sich ein Überstand 18 in Form von vier Überstandabschnitten 19. In jedem Überstandabschnitt 19 ist eine Absaugöffnung 20 für Luft vorgesehen. Darüber kann im Peripheriebereich 17 der Vakuumspannplatte 10 Luft abgesaugt werden. Dies ist beispielsweise von Vorteil, wenn sich der Wafer partiell von der Vakuumspannplatte 10 ablöst. In den dabei entstehenden Spalt kann nunmehr keine Lust mehr eindringen, so dass ein Zusammenbrich des Vakuums verhindert werden kann.

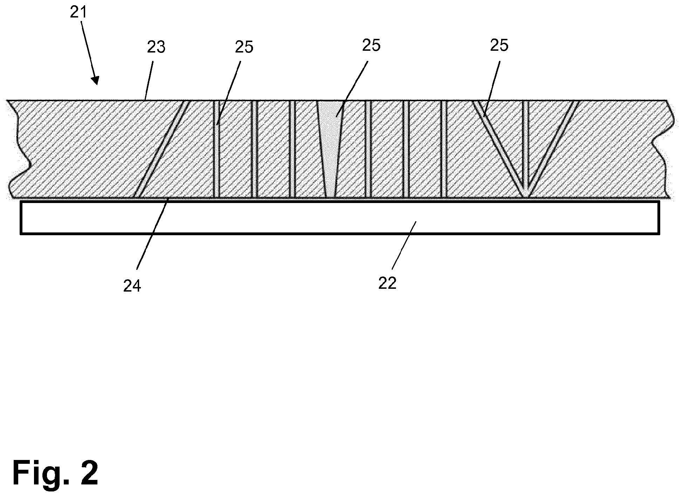

Auf der Vakuumspannplatte 10 kann eine weitere Vakuumplatte 21 fixiert, beispielsweise angeklebt sein, die in Figur 2 dargestellt ist. Damit ein Verrutschen des Wafers 22 verhindert wird, ist es sinnvoll, zwischen dem Wafer 22 und der Vakuumspannplatte 10 eine solche Vakuumplatte 21 vorzusehen. Die Vakuumplatte 21 weist eine erste äußere Oberfläche 23 und eine zweite äußere Oberfläche 24 auf, wobei sich eine Anzahl von Vakuumkanälen 25 von den äußeren Oberflächen 23, 24 durch die vakuumplatte 21 hindurch erstreckt. Als Vakuumkanäle 25 können senkrechte und schräge Bohrungen geringen Durchmessers vorgesehen sein. Zur weiteren Strömungsoptimierung können die Vakuumkanäle 25 unterschiedliche Geometrien haben, beispielsweise eine zylindrische Geometrie, eine konische Geometrie oder dergleichen.

### Bezugszeichenliste

- 10: Vakuumspannplatte
- 11: Vakuumzone
- 12: Vakuumzone
- 13: Exzentrische Form
- 14: Ansaugoberfläche
- 15: Ansaugnut
- 16: Ansaugöffnung
- 17: Peripheriebereich
- 18: Überstand
- 19: Überstandabschnitt
- 20: Absaugöffnung
- 21: Vakuumplatte
- 22: Wafer
- 23: Äußere Oberfläche
- 24: Äußere Oberfläche
- 25: Vakuumkanal

## Patentansprüche

1. Vakuumspannvorrichtung zum Aufspannen von Werkstücken, insbesondere zum Aufspannen von flachen Substraten, mit einer Vakuumspannplatte (10), die über ihre Fläche verteilt eine Anzahl von Ansaugöffnungen (16) aufweist, die in einer Ansaugoberfläche (14) der Vakuumspannplatte (10) ausgebildet sind, oder die mit einer Anzahl von Ansaugnuten (15) in Verbindung stehen, die in einer Ansaugoberfläche (14) der Vakuumspannplatte (10) ausgebildet sind, wobei die Vakuumspannplatte (10) zwei oder mehr voneinander getrennte, einzeln schaltbare Vakuumzonen (11, 12) aufweist, wobei jede Vakuumzone (11, 12) entsprechende Ansaugöffnungen (16) und/oder Ansaugnuten (15) mit Ansaugöffnungen (16) aufweist, wobei die Vakuumspannvorrichtung zwei oder mehr voneinander unabhängige Vakuumkreise aufweist, wobei jede Vakuumzone (11, 12) einem der Vakuumkreise zugeordnet ist oder Bestandteil eines der Vakuumkreise ist, und wobei jeder Vakuumkreis zum Erzeugen eines eigenständigen Vakuums ausgebildet ist, wobei die Vakuumspannplatte (10) kreisförmig ausgebildet ist und **dadurch gekennzeichnet, dass** die Vakuumzonen (11, 12) kreisförmige äußere Begrenzungen aufweisen, die keinen gemeinsamen Mittelpunkt haben.

2. Vakuumspannvorrichtung nach Anspruch 1, **dadurch gekennzeichnet, dass** die Vakuumspannplatte (10) in zwei Vakuumzonen (11, 12) aufgeteilt ist und dass eine erste Vakuumzone (11) flächenmäßig um ein Vielfaches größer ist als die zweite Vakuumzone (12).

3. Vakuumspannvorrichtung nach Anspruch 1 oder 2, **dadurch gekennzeichnet, dass** die Vakuumspannplatte (10) in zwei Vakuumzonen (11, 12) aufgeteilt ist und dass über eine erste Vakuumzone ein Vakuum erzeugt oder bereitgestellt wird, das größer ist als das Vakuum, dass über die zweite Vakuumzone erzeugt oder bereitgestellt wird.

4. Vakuumspannvorrichtung nach einem der Ansprüche 1 bis 3, **dadurch gekennzeichnet, dass** die Vakuumspannplatte (10) kreisförmig ausgebildet ist, und dass wenigstens eine Vakuumzone (12) als Kreissektor oder als Kreissegment ausgebildet ist.

5. Vakuumspannvorrichtung nach einem der Ansprüche 1 bis 4, **dadurch gekennzeichnet, dass** die Vakuumspannplatte (10) als Vakuumplatte ausgebildet ist oder dass vor der Vakuumspannplatte (10) eine Vakuumplatte (21) angeordnet ist, dass die Vakuumplatte (21) eine erste äußere Oberfläche (23) und eine dazu gegenüberliegend zweite äußere Oberfläche (24) aufweist dass die Vakuumplatte (21) eine Anzahl von Vakuumkanälen (25) aufweist, die sich von der ersten äußeren Oberfläche (23) zur zweiten äußeren Oberfläche (24) durch die Vakuumplatte (21) hindurch erstrecken, dass zumindest einzelne Vakuumkanäle (25) sich von einer senkrechten Ausrichtung abweichend zwischen den äußeren Oberflächen (23, 24) durch die Vakuumplatte (21) hindurch erstrecken und/oder dass zumindest einzelne Vakuumkanäle (25) eine von einer zylindrischen Form abweichende Form aufweisen.

6. Vakuumspannvorrichtung nach Anspruch 5, **dadurch gekennzeichnet, dass** sich zumindest einzelne Vakuumkanäle (25) mit einem schrägen Verlauf zwischen den äußeren Oberflächen (23, 24) durch die Vakuumplatte (21) hindurch erstrecken und/oder dass zumindest einzelne Vakuumkanäle (25) einen konischen Verlauf haben.

7. Vakuumspannvorrichtung nach Anspruch 5 oder 6, **dadurch gekennzeichnet, dass** in der Vakuumplatte (21) zumindest einzelne Vakuumkanäle (25) mit jeweils unterschiedlicher Ausrichtung und/oder mit jeweils unterschiedlicher Form ausgebildet sind.

8. Vakuumspannvorrichtung nach einem der Ansprüche 1 bis 7, **dadurch gekennzeichnet dass** die Vakuumspannplatte (10) eine Größe und/oder Kontur aufweist, die mit der Größe und/oder Kontur des zu spannenden Werkstücks, insbesondere des zu spannenden flachen Substrats, korrespondiert.

9. Vakuumspannvorrichtung nach einem der Ansprüche 1 bis 8, **dadurch gekennzeichnet, dass** die Vakuumspannplatte (10) in deren Peripheriebereich (17) zumindest bereichsweise einen Überstand (18) aufweist.

10. Vakuumspannvorrichtung nach Anspruch 9, **dadurch gekennzeichnet, dass** der Überstand (18) umlaufend im Peripheriebereich (17) der Vakuumspannplatte (10) angeordnet oder ausgebildet ist, oder dass der Überstand (18) in Form wenigstens eines Überstandabschnitts (19) im Peripheriebereich (17) der Vakuumspannplatte (10) angeordnet oder ausgebildet ist.

11. Vakuumspannvorrichtung nach einem der Ansprüche 1 bis 10, **dadurch gekennzeichnet, dass** diese zum Aufspannen von Wafern verwendet wird.

## Claims

1. A vacuum clamping device for clamping workpieces, in particular for clamping flat substrates, having a vacuum clamping plate (10), which comprises, distributed over its surface, a plurality of suction openings (16), which are formed in a suction surface (14) of said vacuum clamping plate (10), or which are associated with a plurality, of suction grooves (15), which are formed in a suction surface (14) of said vacuum clamping plate (10), whereby the vacuum clamping plate (10) comprises two or more separate, individually switchable vacuum zones (11,12), each vacuum zone (11, 12) comprising respective suction openings (16) and/or suction grooves (15) having suction openings (16), whereby the vacuum clamping device comprises two or more independent vacuum circuits, whereby each vacuum zone (11, 12) is associated to one of the vacuum circuits or is part of one of the vacuum circuits, and whereby each vacuum circuit is provided for generating an independent vacuum, whereby the vacuum clamping plate (10) is circular shaped, and **characterized in that** the vacuum zones (11, 12) comprise circular outer boundaries, which have no common centre.

2. the vacuum clamping device according to claim 1, **characterized in that** the vacuum clamping plate (10) is divided in two vacuum zones (11, 12) and that a first vacuum zone (11) is a multiple greater in size than the second vacuum zone (12).

3. The vacuum clamping device according to claim 1 or 2, **characterized in that** the vacuum clamping plate (10) is divided in two vacuum zones (11, 12), and that by means of a first vacuum zone a vacuum is generated or provided, which is larger than the vacuum, which is generated or provided by means of the second vacuum zone.

4. The vacuum clamping device according to anyone of claims 1 to 3, **characterized in that** the vacuum clamping plate is circular shaped, and that at least one vacuum zone (12) is formed as a circular sector or as a circular segment.

5. The vacuum clamping device according to anyone of claims 1 to 4, **characterized in that** the vacuum clamping plate (10) is formed as a vacuum plate or that a vacuum pate (21) is disposed in front of said vacuum clamping plate (10), that the vacuum plate (21) comprises a first outer surface (23) and a second outer surface (24) opposite thereto, that the vacuum plate (21) comprises a plurality of vacuum channels (25), which extend from the first outer surface (23) through vacuum plate (21) to the second outer surface (24), that at least some of the vacuum channels (25) extend between the outer surfaces (24, 25) through vacuum plate (21) in an orientation differing from a vertical orientation and/or that at least some of the vacuum channels (25) have a shape differing from a cylindrical shape.

6. The vacuum clamping device according to claim 5, **characterized in that** at least some of the vacuum channels (25) extend between the outer surfaces (24, 25) through vacuum plate (21) with an oblique course and/or that at least some of the vacuum channels (25) have a conical shape.

7. The vacuum clamping device according to claim 5 or 6, **characterized in that** in the vacuum plate (21) at least individual vacuum channels (25) are formed each having a different orientation and/or a different shape.

8. The vacuum clamping device according to anyone of claims 1 to 7, **characterized in that** the vacuum clamping plate (10) has a size and/or a contour, which corresponds to the size and/or to the contour of the workpiece to be clamped, in particular the flat substrate to be clamped.

9. The vacuum clamping device according to anyone of claims 1 to 8, **characterized in that** the vacuum clamping plate (10) in its peripheral area (17) at least partially comprises a protrusion.

10. The vacuum clamping device according to claim 9, **characterized in that** the protrusion (18) is circumferentially arranged or provided in the peripheral area (17) of the vacuum clamping plate (10), or that the protrusion (18) is arranged or provided as at least one protruding portion (19) in the peripheral area (17) of the vacuum clamping plate (10).

11. The vacuum clamping device according to anyone of claims 1 to 10, **characterized in that** it is used for clamping wafers.

## Revendications

1. Dispositif de serrage sous vide servant à serrer des pièces, en particulier servant à serrer des substrats plats, comprenant un panneau de serrage sous vide (10), qui présente sur sa surface de manière répartie un nombre donné d'ouvertures d'aspiration (16), qui sont réalisées dans une surface d'aspiration (14) du panneau de serrage sous vide (10), ou qui sont reliées à un nombre donné de rainures d'aspiration (15), qui sont réalisées dans une surface d'aspiration (14) du panneau de serrage sous vide (10), dans lequel le panneau de serrage sous vide (10) présente deux zones sous vide (11, 12) ou plus séparées l'une de l'autre, pouvant être activées individuellement, dans lequel chaque zone sous vide (11, 12) présente des ouvertures d'aspiration (16) correspondantes et/ou des rainures d'aspiration (15) correspondantes pourvues d'ouvertures d'aspiration (16), dans lequel le dispositif de serrage sous vide présente deux circuits sous vide ou plus indépendants les uns des autres, dans lequel chaque zone sous vide (11, 12) est associée à l'un des circuits sous vide ou fait partie intégrante d'un des circuits sous vide, et dans lequel chaque circuit sous vide est réalisé afin de générer un vide autonome, dans lequel le panneau de serrage sous vide (10) est réalisé de manière à présenter une forme circulaire, et **caractérisé en ce que** les zones sous vide (11, 12) présentent des délimitations extérieures de forme circulaire, qui n'ont aucun point central commun.

2. Dispositif de serrage sous vide selon la revendication 1, **caractérisé en ce que** le panneau de serrage sous vide (10) est réparti dans deux zones sous vide (11, 12), et qu'une première zone sous vide (11) est plus grande en matière de surface d'un multiple que la deuxième zone sous vide (12).

3. Dispositif de serrage sous vide selon la revendication 1 ou 2, **caractérisé en ce que** le panneau de serrage sous vide (10) est réparti en deux zones sous vide (11, 12), et qu'est produit ou fourni, par l'intermédiaire d'une première zone sous vide, un vide, qui est plus grand que le vide produit ou fourni par l'intermédiaire de la deuxième zone sous vide.

4. Dispositif de serrage sous vide selon l'une quelconque des revendications 1 à 3, **caractérisé en ce que** le panneau de serrage sous vide (10) est réalisé de manière à présenter une forme circulaire, et qu'au moins une zone sous vide (12) est réalisée sous la forme d'un secteur circulaire ou sous la forme d'un segment circulaire.

5. Dispositif de serrage sous vide selon l'une quelconque des revendications 1 à 4, **caractérisé en ce que** le panneau de serrage sous vide (10) est réalisé sous la forme d'un panneau sous vide, ou qu'un panneau sous vide (21) est disposé avant le panneau de serrage sous vide (10), que le panneau sous vide (21) présente une première surface extérieure (23) et une deuxième surface extérieure (24) lui faisant face, que le panneau sous vide (21) présente un nombre donné de canaux sous vide (25), qui s'étendent depuis la première surface extérieure (23) vers la deuxième surface extérieure (24) au travers du panneau sous vide (21), qu'au moins divers canaux sous vide (25) s'étendent en s'écartant d'une orientation perpendiculaire entre les surfaces extérieures (23, 24) au travers du panneau sous vide (21), et/ou qu'au moins divers canaux sous vide (25) présentent une forme s'écartant d'une forme cylindrique.

6. Dispositif de serrage sous vide selon la revendication 5, **caractérisé en ce qu'**au moins divers canaux de vide (25) s'étendent avec un profil oblique, entre les surfaces extérieures (23, 24) au travers du panneau sous vide (21), et/ou qu'au moins divers canaux de vide (25) présentent un profil conique.

7. Dispositif de serrage sous vide selon la revendication 5 ou 6, **caractérisé en ce qu'**au moins divers canaux sous vide (25) présentant respectivement une orientation différente et/ou avec une forme respectivement différente sont réalisés dans le panneau sous vide (21).

8. Dispositif de serrage sous vide selon l'une quelconque des revendications 1 à 7, **caractérisé en ce que** le panneau de serrage sous vide (10) présente une grandeur et/ou un contour, qui correspondent à la taille et/ou au contour de la pièce à serrer, en particulier du substrat plat à serrer.

9. Dispositif de serrage sous vide selon l'une quelconque des revendications 1 à 8, **caractérisé en ce que** le panneau de serrage sous vide (10) présente, dans sa zone périphérique (17), au moins par endroits un débord (18).

10. Dispositif de serrage sous vide selon la revendication 9, **caractérisé en ce que** le débord (18) est disposé ou réalisé en périphérie dans la zone périphérique (17) du panneau de serrage sous vide (10), ou que le débord (18) est disposé ou réalisé sous la forme d'au moins une section de débord (19) dans la zone périphérique (17) du panneau sous vide (10).

11. Dispositif de serrage sous vide selon l'une quelconque des revendications 1 à 10, **caractérisé en ce qu'**il est utilisé aux fins du serrage de tranches.
